Europäisches Patentamt

European Patent Office

Office européen des brevets

(19)

(11) Numéro de publication: **0 021 878**
**B1**

(12) **FASCICULE DE BREVET EUROPEEN**

(45) Date de publication du fascicule du brevet: **09.02.83**

(51) Int. Cl.³: **H 03 H 2/00**

(21) Numéro de dépôt: **80400726.8**

(22) Date de dépôt: **23.05.80**

(54) Dispositif à ondes magnétostatiques comportant des moyens atténuateurs et son procédé de fabrication.

(30) Priorité: **06.06.79 FR 7914439**

(43) Date de publication de la demande:
**07.01.81 Bulletin 81/1**

(45) Mention de la délivrance du brevet:
**09.02.83 Bulletin 83/6**

(84) Etats contractants désignés:
**DE GB IT NL**

(56) Documents cités:
**J. Appl. Phys. 49(3), March 1978 New York US J.H. COLLINS et al.: "Magnetostatic wave terminations", pages 1800—1802**

**IEEE TRANSACTIONS ON MICROWAVE THEORY AND TECHNIQUES; VOL: MTT—27, no. 2, février 1979 New York US S.R. SESHADRI: "Magnetic wave interactions in a periodically corrugated YIG film", pages 199—204.**

(73) Titulaire: **THOMSON-CSF**
**173, Boulevard Haussmann**
**F-75379 Paris Cedex 08 (FR)**

(72) Inventeur: **Volluet, Gérard**
**"THOMSON-CSF" SCPI 173, bld Haussmann**
**F-75360 Paris Cedex 08 (FR)**
Inventeur: **Cohen, Daniel**
**"THOMSON-CSF" SCPI 173, bld Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

(56) Documents cités

INTERNATIONAL JOURNAL OF ELECTRONICS, vol. 34, no. 3, 1973 Londres (G.B.) J. H. COLLINS et al.: "Propagating magnetic waves in thick films. A complementary technology to surface wave acoustics", pages 319—351

IEEE TRANSACTIONS ON MAGNETICS, vol. Mag. 7 no. 1, mars 1971, New York US R. M. HORNREICH et al.: "Magnetostrictive phenomena in metallic materials and some of their device applications", pages 29—48

IEEE TRANSACTIONS ON MAGNETICS vol. Mag. 11, no. 5, septembre 1975 New York US D.C. WEBB et al.: "Magnetostatic propagation in thin films of liquid phase epitaxy YIG", pages 1259—1261

IEEE INTERNATIONAL MICROWAVE SYMPOSIUM DIGEST, 21—23 juin 1977 San Diego, California US J.H. COLLINS et al.: "Microwave devices based on magnetostatic wave reflecting arrays", pages 331—334

IEEE TRANSACTIONS ON MICROWAVE THEORY AND TECHNIQUES, vol. MTT—23 no. 12, décembre 1975 New York US A.K. GANGULY et al.: "Microstrip excitation of magnetostatic surface waves; theory and experiment" pages 998—1006

Dispositif à ondes magnétostatiques comportant des moyens atténuateurs
et son procédé de fabrication

La présente invention se rapporte aux dispositifs à ondes magnétostatiques qui comprennent une lamelle ferrimagnétique à la surface de laquelle sont agencées des électrodes d'excitation filiformes. Lorsqu'on fait circuler un courant alternatif de fréquence appropriée le long de ces électrodes et lorsqu'on soumet la lamelle à un champ magnétique de polarisation dont l'intensité est choisie en fonction de cette fréquence, des ondes magnétostatiques de volume ou de surface sont émises perpendiculairement à la direction du courant excitateur. Ces ondes peuvent être recueillies par une autre électrode, ce qui donne naissance à un courant induit. Avec deux électrodes filiformes disposées en vis-à-vis et jouant respectivement les rôles de transducteurs d'émission et de réception, on peut réaliser une transmission par ondes magnétostatiques présentant une fonction de transfert déterminée. Cependant, cette fonction de transfert présente des ondulations gênantes produites par les réflexions que subissent les ondes magnétostatiques en atteignant les bords de la lamelle ferrimagnétique.

Pour pallier cet inconvénient, on peut traiter les bords de la lamelle ferrimagnétique de façon à diminuer les réflexions d'ondes magnétostatiques. Dans ce sens, on peut mentionner la méthode qui consiste à découper obliquement les bords de la lamelle ferrimagnétique par rapport à la direction de propagation des ondes magnétostatiques. Ceci a pour effet d'allonger le trajet des ondes réfléchies avant qu'elles n'atteignent les transducteurs, mais cette méthode dont l'efficacité n'est que partielle, entraîne un gaspillage de matière puisqu'il faut donner une forme en biseau à la plaquette ferrimagnétique. Une autre solution consiste à utiliser un mécanisme de pertes. L'article de J.H. COLLINS, D.M. HASTIE, J.M. OWENS et C.V. SMITH Jr intitulé "MAGNETOSTATIC WAVE TERMINATIONS" publié dans la revue JOURNAL OF APPLIED PHYSICS. 49(3) Mars 1978 New York pages 1800—1802 suggère qu'en endommageant la surface d'une couche YIG, on obtient une largeur de raie accrue dans la région endommagée. L'article suggère que la couche YIG endommagée peut être formée par abrasion mécanique de la surface avec du carbure de silicium grain 300. Dans cet ordre d'idée, on peut envisager de roder les bords de la plaquette à l'aide d'un outil chargé d'abrasifs, mais il est difficile d'obtenir de façon reproductible une transition suffisamment progressive entre la partie rodée et la partie non rodée pour que les réflexions soient fortement réduites. La diminution des réflexions peut encore être obtenue en déposant sur la plaquette ferrimagnétique un ruban magnétique ou des particules magnétiques présentant des pertes magnétiques importantes, mais la discontinuité des propriétés magnétiques de ce dépôt et du substrat constitue un facteur de réflexion. Dans le cas de la technologie utilisant comme substrat un grenat ferrimagnétique tel que le grenat d'yttrium et de fer, on peut réaliser un dépôt par épitaxie d'un matériau similaire, mais à fortes pertes magnétiques tel que le grenat de terbium et de fer. Cette technologie est cependant onéreuse et complexe et elle laisse subsister un facteur de réflexion, puisque ce dépôt introduit une discontinuité d'épaisseur.

On sait actuellement fabriquer des substrats pour dispositifs à ondes magnétostatiques qui présentent une faible atténuation. A cet effet, on prend pour base un support en grenat de galodinium et gallium (GGG) dont la surface a été soigneusement polie pour atteindre une faible densité de défauts, par exemple inférieure à $1/cm^2$. On fait croître sur ce support par épitaxie en phase gazeuse ou liquide un film mince de grenat d'yttrium et de fer (YIG) pour lequel la raie de résonance ferrimagnétique a une largeur qui ne dépasse pas une fraction d'Oersted. Il en résulte des pertes de propagation de l'ordre de 38 dB/$\mu$s en bande S. Afin d'obtenir localement une forte atténuation sans créer de discontinuité susceptible d'engendrer des réflexions, l'invention propose d'utiliser une technique de sablage créant à la surface du film un nombre important de défauts microscopiques grâce auxquels on peut élargir sensiblement la raie de résonance ferrimagnétique ce qui rend le film localement plus absorbant.

L'invention a pour objet un dispositif à ondes magnétostatiques comportant des moyens atténuateurs localisés sur un substrat ferrimagnétique de manière à recevoir les ondes magnétostatiques provenant de transducteurs constitués par des électrodes filiformes, lesdits moyens atténuateurs comprenant au moins une zone dont l'atténuation a été accrue par un traitement mécanique abrasif local producteur de défauts élargissant la raie de résonance ferrimagnétique, caractérisé en ce que lesdits défauts sont les impacts laissés sur ledit substrat par un jet de particules abrasives assurance ledit traitement.

L'invention a également pour objet le procédé de fabrication du dispositif mentionné ci-dessus qui consiste à protéger par masquage les zones du substrat qui ne doivent pas présenter de détériorations superficielles et à effectuer ledit traitement au moyen dudit jet dans les zones restantes; lesdits impacts étant d'importance telle qu'aucune discontinuité marquée ne soit créée entre les zones protégées et restantes de nature à réfléchir lesdites ondes magnétostatiques.

L'invention sera mieux comprise au moyen de la description ci-après et des figures annexées, parmi lesquelles:

la figure 1 illustre la structure des domaines au sein d'une couche ferrimagnétique épitaxiée;

la figure 2 est une vue isométrique d'un premier dispositif à ondes magnétostatiques selon l'invention;

la figure 3 représente deux dispositifs à ondes magnétostatiques réunis sur un même substrat ferrimagnétique;

la figure 4 représente une variante de réalisation du dispositif à ondes magnétostatiques de la figure 1;

la figure 5 illustre le procédé de fabrication des dispositifs représentés aux figures 2 à 4;

la figure 6 représente la fonction de transfert d'un dispositif à ondes magnétostatiques.

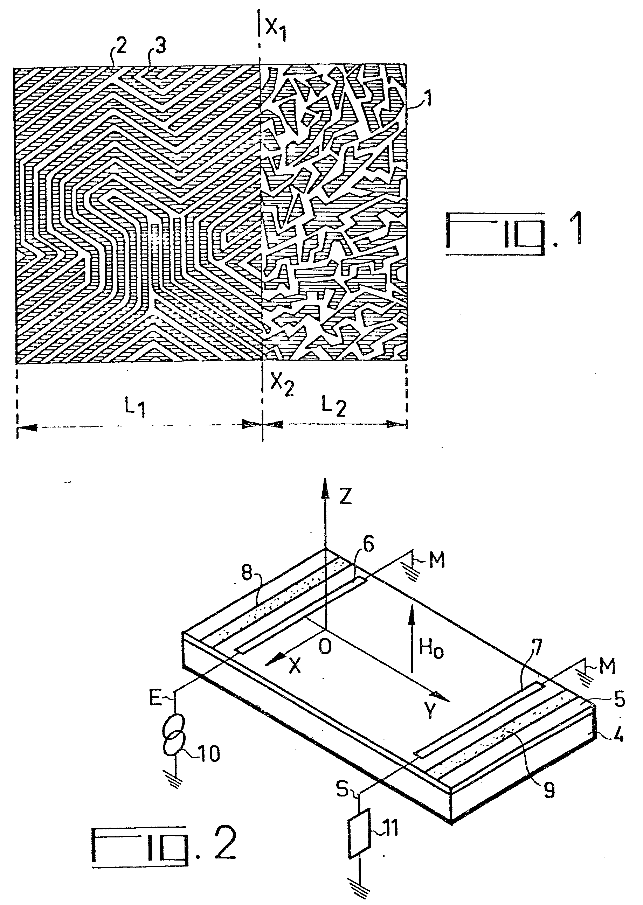

Sur la figure 1, on peut voir la structure d'un film mince ferrimagnétique 1 dont la partie $L_1$ située à gauche de l'axe $X_1X_2$ est pratiquement dépourvue de défauts et dont la partie $L_2$ située à droite de l'axe $X_1X_2$ a été détériorée superficiellement par sablage. Cette structure peut être visualisée en champ magnétique faible ou nul à l'aide d'un microscope polarisant dans le cas où la lamelle ferrimagnétique est assez mince pour permettre une observation par transmission optique. Par effet Faraday, on peut distinguer les domaines magnétiques 2 et 3. Dans la région $L_1$ ces domaines se présentent sous la forme de bandes claires et obscures formant un agencement d'aspect régulier. L'écartement des bandes change avec l'intensité du champ magnétique appliqué. La forte mobilité des bandes avec un champ appliqué de faible intensité permet d'identifier cette région comme étant celle où les ondes magnétostatiques peuvent se propager avec une faible atténuation. Au contraire, le sablage appliqué dans la région $L_2$ a engendré en surface de nombreux défauts qui ont complètement changé l'aspect des domaines magnétiques. Ceux-ci sont en effet morcelés de façon très irrégulière et leur mobilité est pratiquement nulle lorsque le champ magnétique varie.

L'expérience montre qu'un sablage de faible importance qui n'engendre pas de discontinuité marquée entre les deux régions $L_1$ et $L_2$ a complètement changé l'aspect et la mobilité des domaines magnétiques. De plus, si la région $L_2$ reçoit un onde magnétostatique, elle atténue beaucoup plus fortement cette onde que la région $L_1$. L'onde magnétostatique subit une atténuation pratiquement totale pour une distance de parcours de 2 mm dans la région $L_2$. L'absence de discontinuité marquée fait que le franchissement de la ligne $X_1X_2$ ne donne pas lieu à une réflexion. Hormis les pertes, les propriétés magnétiques des régions $L_1$ et $L_2$ sont les mêmes. L'observation basée sur l'effet Faraday permet de doser l'action du sablage en densité, durée et distance buse-échantillon de manière à satisfaire au critère de perturbation des domaines magnétiques, c'est-à-dire à leur aspect irrégulier et à l'absence de mobilité.

Le dispositif à ondes magnétostatiques de la figure 2 met en oeuvre la technique de sablage en vue d'absorber les ondes magnétostatiques de volume excitées par l'électrode filiforme 6. Le dispositif se compose par exemple d'un support 4 en grenat de galodinium-gallium sur lequel on a épitaxié un film 5 de grenat d'yttrium-fer. Un champ magnétique $H_o$ est appliqué perpendiculairement à la surface XOY de film 5. Le transducteur d'émission des ondes magnétostatiques de volume est constitué par l'électrode 6 orientée parallèlement à l'axe OX. L'entrée E du transducteur d'émission est reliée à un générateur électrique 10 et l'extrémité opposée est reliée à la masse M. Le transducteur 6 est à rayonnement bilatéral. Les ondes rayonnées en sens inverse de l'axe OY sont absorbées par la zone sablée 8 qui précède le bord arrière du film 5. Les ondes rayonnées dans le sens de l'axe OY sont reçues par le transducteur de réception 7 constitué lui aussi par une électrode filiforme 7. L'électrode 7 a une extrémité reliée à la masse et l'autre extrémité S alimente une charge électrique 11. Les ondes magnétostatiques de volume qui ont pu franchir le transducteur 7 sont absorbées par une zone sablée 9 qui précède le bord avant du film 5. Bien entendu, la configuration des électrodes 6 et 7, n'est pas limitée à un seul élément rectiligne par transducteur. On peut aussi adopter une configuration en méandre où les éléments rayonnants forment un réseau ou une grille de barreaux parallèles interconnectés. Il va sans dire que des zones sablées 8 et 9 peuvent s'étendre jusqu'aux bords du film 5.

Sur la figure 2, les zones d'atténuation 8 et 9 s'opposent à la réflexion des ondes magnétostatiques de volume. On peut également mettre en oeuvre une zone d'atténuation pour s'opposer à la transmission des ondes magnétostatiques entre deux dispositifs disposés en cascade sur un substrat commun.

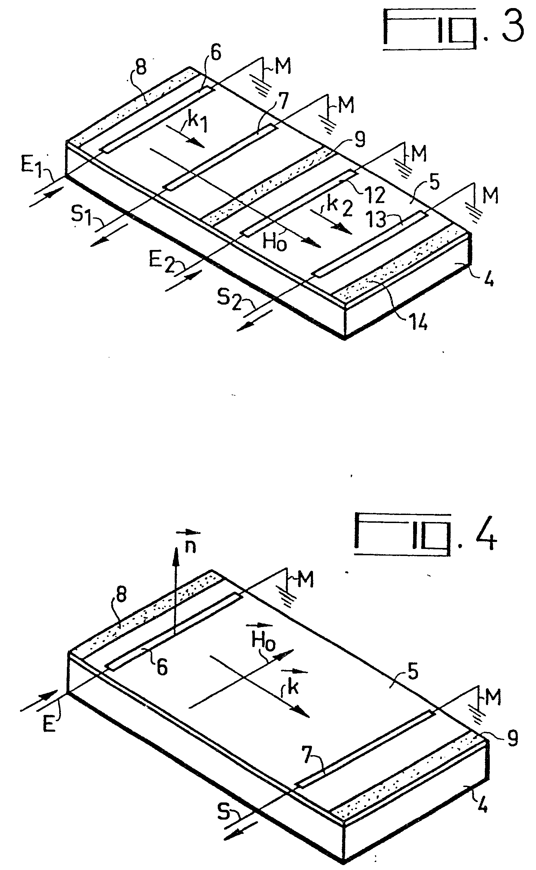

La figure 3 illustre un tel agencement où les mêmes références désignent les mêmes éléments que sur la figure 2. L'agencement de la figure 3 diffère du précédent par l'orientation du champ magnétique inducteur Ho qui est dans le plan du film 5 et perpendiculaire aux électrodes 6, 7, 12 et 13. Les ondes échangées sont encore des ondes magnétostatiques de volume émises bilatéralement. L'électrode 12 constitue le transducteur d'émission d'un second dispositif $E_2S_2$ qui est isolé du premier dispositif $E_1S_1$ par la zone d'atténuation 9. L'électrode 13 joue le rôle de transducteur de réception pour le second dispositif d'échange. La zone d'atténuation 14 sert à empêcher la réflexion des ondes magnétostatiques qui ont pu franchir le transducteur 13. On voit que les échanges par ondes magnétostatiques de volume symbolisées par les vecteurs d'ondes $k_1$ et $k_2$ sont efficacement découplés par la présence de la zone d'atténuation 9.

La création par sablage de zones d'atténuation est également efficace pour s'opposer à la transmission ou à la réflexion d'ondes magnétostatiques de surface.

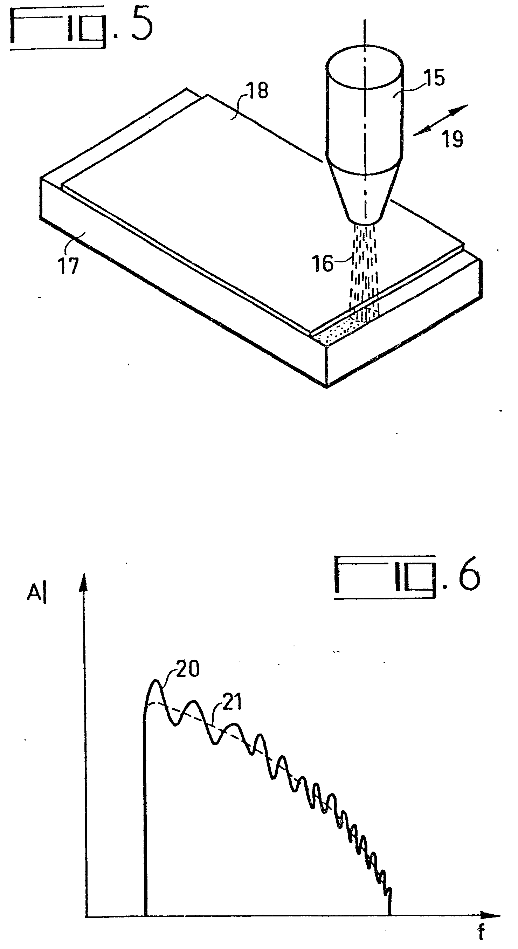

Le dispositif de la figure 4 diffère du dispositif de la figure 2 par le fait que le champ inducteur $H_o$ est orienté parallèlement au conducteur 6. Dans ce cas, les ondes magnétostatiques sont des ondes de surface excitées préférentiellement suivant une direction par le transducteur 6. La direction d'émission est représentée par le vecteur d'onde $\vec{k}$. L'orientation préférentielle du vecteur $\vec{k}$, est parallèle au vecteur produit vectoriel $\vec{H_o} \times \vec{n}$, où $\vec{n}$ désigne la normale à la surface du film 5 dirigée vers l'extérieur du film 5. La zone d'atténuation 9 absorbe les ondes magnétostatiques de surface émises par le transducteur 6 et qui ont franchi le transducteur récepteur 7. La zone d'atténuation 8 permet d'absorber les ondes résiduelles qui, malgré l'émission pseudo-unidirectionnelle, peuvent se réfléchir sur le bord arrière du film 5.

Sur la figure 5, on peut voir un substrat ferrimagnétique 17 au cours de l'opération de sablage. La zone de propagation dans laquelle on désire conserver une faible atténuation est protégée par un masque 18. Le jet de particules 16 est issu d'une buse 15 dirigée vers la zone d'absorption non masquée. On peut déplacer la buse 15 dans la direction 19 si la zone d'impact des particules 16 ne recouvre pas complètement la zone d'absorption désirée.

Il y a lieu de noter que dans cas d'une structure dans laquelle on épitaxie le matériau ferrimagnétique sur un support préalablement poli, on peut effectuer le sablage de la surface du support avant épitaxie. Lors de la croissance du film épitaxie, l'état de surface du support est tel que les zones d'atténuation désirées présentent de nombreux défauts. Bien entendu, les zones d'atténuation sont moins bien délimitées que lorsqu'on effectue le sablage à la surface du film épitaxié.

La figure 6 illustre l'amélioration obtenue par la technique de sablage décrite ci-dessus. Le diagramme de la figure 6 montre en traite plein la fonction de transfert 20 d'un dispositif à ondes magnétostatiques non muni de zones d'atténuation. Cette fonction de transfert présente des ondulations imputables aux réflexions parasites. En prévoyant des zones d'atténuation par sablage, la fonction de transfert présente une allure plus régulière représentée par la courbe en pointillé 21. En abscisse on a porté la fréquence f et en ordonnée le module $|A|$ du rapport de transmission. La technique du sablage est particulièrement simple à mettre en oeuvre. Comme elle n'introduit pas de discontinuité sensible dans la surface de la lamelle ferrimagnétique, il est possible de photograver des motifs recouvrant les zones sablées, car l'état de surface de ces zones est peu détérioré.

## Revendications

1. Dispositif à ondes magnétostatiques comportant des moyens atténuateurs (8, 9) localisés sur un substrat ferrimagnétique (5) de manière à recevoir les ondes magnétostatiques provenant de transducteurs (6, 7) constitués par des électrodes filiformes, lesdits moyens atténuateurs comprenant au moins une zone (8, 9) dont l'atténuation a été accrue par un traitement mécanique abrasif local producteur de défauts élargissant la raie de résonance ferrimagnétique, caractérisé en ce que lesdits défauts sont les impacts laissés sur ledit substrat par un jet de particules abrasives (16) assurant ledit traitement.

2. Dispositif selon la revendication 1, caractérisé en ce que cette zone (8, 9) est une zone absorbante marginale.

3. Dispositif selon la revendication 1, caractérisé en ce que cette zone (9) située à l'intérieure de l'étendue du substrat, est une zone absorbante de découplage entre deux ou plusieurs cellules échangeant des ondes magnétostatiques.

4. Dispositif selon l'une quelconque des revendications 1 à 3, caractérisé en ce qu'il est polarisé magnétiquement de manière à propager des ondes magnétostatiques de volume ou de surface.

5. Dispositif selon l'une quelconque des revendications 1 à 4, caractérisé en ce que le substrat ferrimagnétique (5) est épitaxié sur un support (4).

6. Dispositif selon la revendication 5, caractérisé en ce que les défauts de surface sont situés sur la surface libre du substrat.

7. Dispositif selon la revendication 5, caractérisé en ce que les défauts de surface sont situés à l'interface entre le substrat ferrimagnétique (5) et son support (4).

8. Procédé de fabrication du dispositif selon la revendication 1, caractérisé en ce qu'il consiste à protéger par masquage (18) les zones du substrat (17) qui ne doivent pas présenter de détériorations superficielles et à effectuer ledit traitement au moyen dudit jet (16) dans les zones restantes; lesdits impacts étant d'importance telle qu'aucune discontinuité marquée ne soit créée entre les zones protégées et restantes de nature à réfléchir lesdites ondes magnétostatiques.

9. Procédé selon la revendication 8, caractérisé en ce que le dosage de l'opération d'abrasion par jet est reconnu suffisant dès que la perturbation des domaines magnétiques se traduit par un morcellement irrégulier et une absence de mobilité dans les zones soumises à ladite abrasion par jet.

10. Procédé selon la revendication 8, caractérisé en ce que la surface traitée par le jet est la surface libre du substrat.

11. Procédé selon la revendication 8, caractérisé en ce que la surface traitée par le jet est la surface polie d'un support sur laquelle le substrat est épitaxié.

**Patentansprüche**

1. Vorrichtung für magnetostatische Wellen, die Dämpfungsmittel (8, 9) umfasst, welche auf einem ferromagnetischen Substrat (5) derart aufgebracht sind, dass sie die magnetostatische Wellen empfangen, die von Transduktoren (6, 7) erzeugt werden, welche aus fadenförmigen Elektroden gebildet sind, wobei die genannten Dämpfungsmittel mindestens eine Zone (8, 9) umfassen, deren Dämpfung sich durch örtliches mechanisches, Fehler erzeugendes Abschleifen erhöht wurde, wobei die Fehler die ferrimagnetische Resonanzlinie verbreitet, dadurch gekennzeichnet, dass die genannten Fehler die Druckstellen sind, die auf dem Substrat durch die Einwirkung zwecks dieses Abschleifens angewandten Strahls abrasiver Teilchen (16) entstehen.

2. Vorrichtung gemäss Anspruch 1, dadurch gekennzeichnet, dass die genannte Zone (8, 9) eine absorbierende Randzone ist.

3. Vorrichtung gemäss Anspruch 1, dadurch gekennzeichnet, dass die genannte Zone (9), die sich innerhalb des Substrats befindet, eine absorbierende Entkopplungszone zwischen zwei oder mehr Zellen ist, die magnetostatische Wellen austauschen.

4. Vorrichtung gemäss einem der Ansprüche 1 bis 3, dadurch gekennzeichnet, dass sie magnetisch derart polarisiert ist, dass sie magnetostatische Raumoder Oberflächenwellen aussendet.

5. Vorrichtung gemäss einem der Anspruch 1 bis 4, dadurch gekennzeichnet, dass das ferrimagnetische Substrat (5) epitaxial auf eine Unterlage (4) ist.

6. Vorrichtung gemäss Anspruch 5, dadurch gekennzeichnet, dass sich die Oberflächenfehler auf der freien Oberfläche des Substrats (5) befinden.

7. Vorrichtung gemäss Anspruch 5, dadurch gekennzeichnet, dass sich die Oberflächenrisse auf der Berührungsfläche des ferrimagnetischen Substrats (5) und seiner Unterlage (4) befinden.

8. Verfahren zur Herstellung der Vorrichtung gemäss Anspruch 1, dadurch gekennzeichnet, dass es darin besteht, die nicht der Oberflächenveränderung zu unterwerfenden Zonen des Substrats (17) durch Maskierung (18) zu schützen, und die Behandlung mit Hilfe des genannten Strahls (16) in den übrigen Zonen durchzuführen, wobei die genannten Druckstellen so beschaffen sind, dass keine wahrnehmbare, die Reflexion der magnetostatischen Wellen hervorrufenden Unstätigkeit zwischen den geschutzten und ungeschützten Zonen ensteht.

9. Verfahren gemäss Anspruch 8, dadurch gekennzeichnet, dass die durch den Strahl erzielte Abschleifintensität dann als ausreichend betrachtet wird, wenn die Störung des magnetischen Feldes sich durch ein unregelmässiges Aufbrechen und die Abwesenheit von Beweglichkeit in den Zonen bemerkbar macht, die dem Abschliefen durch den Strahl unterworfen wurden.

10. Verfahren gemäss Anspruch 8, dadurch gekennzeichnet, dass die durch den Strahl behandelte Oberfläche eine freie Oberfläche des Substrats ist.

11. Verfahren gemäss Anspruch 8, dadurch gekennzeichnet, dass die durch den Strahl behandelte Oberfläche die polierte Oberfläche der Unterlage ist, auf die das Substrat aufgebracht wurde.

**Claims**

1. Device for magnetostatic waves comprising attenuator means (8, 9) positioned on a ferromagnetic substrate (5) in such a way as to receive the magnetostatic waves issuing from transducers (6, 7) formed of filament-shaped electrodes, with said attenuator means comprising at least one zone (8, 9), whose attenuation has been increased by a local mechanical abrasive treatment, causing flaws which enlarge the line of ferromagnetic resonance, characterized in that said flaws are the impacts left on said substrate by a blast of abrasive particles (16) ensuring said treatment.

2. Device according to claim 1, characterised in that said zone (8, 9) is a marginal absorbing zone.

3. Device according to claim 1, characterized in that said zone (9), which is situated inside the area of the substrate, is a decoupling absorbing zone between two or several magnetostatic waves exchanging cells.

4. Device according to any of claims 1 to 3, characterized in that it is polarized magnetically in such a way as to propagate the volume or surface magnetostatic waves.

5. Device according to any of claims 1 to 4, characterized in that the ferromagnetic substrate (5) is epitaxial to the support (4).

6. Device according to claim 5, characterized in that the surface flaws are situated on the free surface of the substrate.

7. Device according to claim 5, characterized in that the surface flaws are situated at the interface between the ferromagnetic substrate (5) and its support (4).

8. Process for manufacturing the device according to claim 1, characterized in that it consists in protecting by masking (18) the substrate zones (17) which must not be subjected to surface deterioration and to carry out said treatment by means of said blast (16) in the remaining zones, said impacts being such that no noticeable discontinuity is created between the protected and untreated zones which could reflect said magnetostatic waves.

9. Process according to claim 8, characterized in that the dosage of the operation of blast abrasion is considered as sufficient once the perturbation of the magnetic field is expressed as irregular fracturing and absence of mobility in the zones submitted to said blast abrasion.

10. Process according to claim 8, characterized in that the surface treated by the blast is the free surface of the substrate.

11. Process according to claim 8, characterized in that the surface treated by the blast is the polished surface of a support on which the substrate is epitaxial.

Fig.1

Fig.2

Fig.3

Fig.4

Fig. 5

Fig. 6